# EUROPEAN PATENT APPLICATION

(11) **EP 3 648 174 A1**
(43) Date of publication of application: **06.05.2020**
(21) Application number: 18306436.9
(22) Date of filing: 31.10.2018
(51) Int. Cl.: H01L 31/02, H01L 31/0216

(54) **PHOTOVOLTAIC ASSEMBLY**

(71) Applicant: Total SA, 92400 Courbevoie (FR)
(72) Inventor: JAFFRENNOU, Périne, 92190 MEUDON (FR); POULAIN, Gilles, 92160 Antony (BE); FILONOVICH, Sergej, 91470 LIMOURS (FR)
(74) Representative: Croonenbroek, Thomas Jakob

(57) **Abstract**

The invention relates to a photovoltaic cell, comprising :
- a silicon crystal cell body (7) comprising a cell front surface (S),
- an antireflection coating covering (11, 13) at least partially the cell front surface (S), comprising at least two surfaces (3, 4) exhibiting different colours forming a decorative pattern,
- metallic front contacts (5), providing electrical connection for the generation of electrical current using the photovoltaic effect, forming at least partially a contour of one of the two antireflection coating surfaces (3, 4) exhibiting different colours.

The invention also relates to the associated photovoltaic module and the associated manufacturing process.

## Description

### FIELD OF INVENTION

The present invention relates to a photovoltaic assembly, converting solar energy into electrical power. The invention relates in particular to a decoration of the solar panels and enhancing the harvesting of photovoltaic energy.

### BACKGROUND AND PRIOR ART

Photovoltaic assemblies provide a renewable energy source, producing no carbon dioxide, without consumption of fossil fuels. Their decreasing prices prompt building owners to install them on walls and roofs to provide an additional cheap power source.

However, the presence of the photovoltaic modules or panels on a facade may degrade the overall aesthetic or architecture of the building, since their natural colour and aspect depends essentially on the materials used to produce their solar cells. For example, monocrystalline silicon cell panels have a blue-grey hint, and appear shiny. Polycrystalline silicon cell panels have a flaky appearance with blue-grey colorations.

The surfaces of the photovoltaic modules are also a possible advertising surface, while decorated panels can be integrated more easily in a landscape.

Photovoltaic devices with front contacts are well known in the art. For example US20050189015, US20110139230, US6091021 disclose silicon wafer based photovoltaic devices including a front contact or front electrodes. By convention, a front side or surface of a photovoltaic device is the side through which the sunlight penetrates for generation of an electrical current by the photovoltaic effect at the p-n / n-p junction of the photovoltaic device. The backside or back-surface of the photovoltaic device is the side opposite to the front side.

It is known to cover the front surface (oriented in the direction of the sun) of the panels with a tinted glass layer, and/or to cover the solar cells with thin layers of dielectric materials of different refractive indexes such as alternating SiO₂ and SiNₓ:H layers to form coloured solar cells and panels. However, the whole surface of every single cell has to be covered in a single colour.

The article "Realization of Colored Multicrystalline Silicon Solar Cells with SiO2/SiNx:H Double Layer Antireflection Coatings" of Minghua Li et al. (International Journal of Photoenergy Vol. 2013) describes the possibilities in terms of colorations and aspects that are possible using the aforementioned thin layers.

However, the application of such colouring thin layers on one cell, mean that only mosaics of the simple cell forms (squares, hexagon etc.) of different colours are feasible.

It is also known to etch portions of cells away in a panel to create motives such as characters of a company name.

The coloration of single cells limits the possibilities in terms of imagery one can obtain. The etching away of cells has on one hand to be done carefully so as not to damage the electrical contacts, which consequently remain visible, and also reduces the overall active surface of the solar modules in that active cell surface is etched away.

In any case, the metallic contacts situated between the single cells degrade the pictures and images represented on the photovoltaic modules.

### SUMMARY OF THE INVENTION

In order to overcome the aforementioned drawbacks, the invention has for object a photovoltaic cell, comprising :
- a silicon crystal cell body comprising a cell front surface,
- an antireflection coating covering at least partially the cell front surface, comprising at least two surfaces exhibiting different colours forming a decorative pattern,
- metallic front contacts, providing electrical connection for the generation of electrical current using the photovoltaic effect, forming at least partially a contour of one of the two antireflection coating surfaces exhibiting different colours.

In such a solar cell, additional metallic contacts are integrated in the decorative pattern. Their positioning at the contours of coloured antireflection layers also allows depositing said layers with reduced precision constraints as the metallic contacts will bridge gaps and cover overlapping.

The additional metallic contacts also improve electric current extraction, so that efficiency losses due to the colouration of a portion of the front surface and/or the active surface lost due to the additional metallic contacts are partially compensated.

The solar cell may further present one or more of the following characteristics, taken separately or in combination.

A portion of the metallic front contacts may also form decorative details of the decorative pattern.

The antireflection coating may comprise at least two layers of different thickness for each of the at least two surfaces of different colours, of two of the following materials : silicon nitride SiNx, silicon oxide SiOx , silicon carbide SiC, aluminium nitride AIN, aluminium oxide AlOx, titanium oxide TiOx.

The antireflection coating may comprise a layer of tinted silicate glass.

The metallic front contacts may be printed front contacts, obtained by printing a metallic particle containing paste and thermal firing through of said paste.

The metallic front contacts may be obtained by plating of metal on a laser ablated contact pattern.

The invention also relates to the associated photovoltaic module, comprising at least one photovoltaic cell as previously described.

The photovoltaic module may comprise a support sheet, on which the photovoltaic cells are arranged in a pattern, and the support sheet may comprise an additional metallic contact forming additional decorative details.

Finally, the invention also relates to the associated process for manufacturing a photovoltaic cell, comprising the steps:
- depositing an antireflection layer on a front surface of a photovoltaic cell comprising at least two surfaces of different colours forming a decorative pattern,
- depositing metallic front contacts, providing electrical connection for the generation of electrical current using the photovoltaic effect, forming at least partially a contour of one of the two antireflection coating surfaces with different colours.

The process may comprise the additional step of depositing additional metallic front contacts (5) forming decorative details of the decorative pattern.

In said process the electric contacts may be deposited by printing of a metal containing paste and thermal firing of said paste.

The electric contacts may alternatively be deposited by performing laser ablation of the antireflection coating and passivation layers of the photovoltaic cell along the intended metallic contact pattern and electroplating of metallic contacts on the laser ablated metallic contact pattern.

The antireflection coating may be deposited using chemical vapour deposition and masks.

The antireflection coating may also be deposited using plasma enhanced chemical vapour deposition and patterned electrodes to selectively deposit the antireflection coating layers on the at least two surfaces of different colours forming a decorative pattern.

The photovoltaic cells and the metallic contacts may be deposited on a polymer support sheet, which is then laminated between a transparent polymer front sheet and a back sheet.

Other benefits and characteristics of the invention will become apparent in light of the following description, based on the figures, given in an illustrating and not limiting fashion, among which:
- Figure 1 is a schematic perspective view of a photovoltaic cell according to the invention,
- Figures 2a, 2b are cutaway views of a portion of the cell of figure 1 according to two different embodiments,
- Figure 3 is a flowchart of the main steps of a process to generate the cell depicted in figure 1,
- Figures 4 to 7 illustrate steps of the method of figure 3,
- Figures 8 to 10 illustrate an alternative method to deposit the metallic contacts,
- Figures 11 and 12 are schematic perspective views of possible arrangements of cells in a photovoltaic module.

### DETAILED DESCRIPTION OF THE INVENTION

The represented and described embodiments are given in an illustrational and not limiting fashion. Other embodiments can be obtained by altering the described embodiments, and by combining different embodiments.

The term "photovoltaic module" as used hereafter designates the most elementary structure for the production of electrical current using the photovoltaic effect. It generally comprises a plurality of interconnected photovoltaic cells, such as defined by the standard IEC-TS61836.

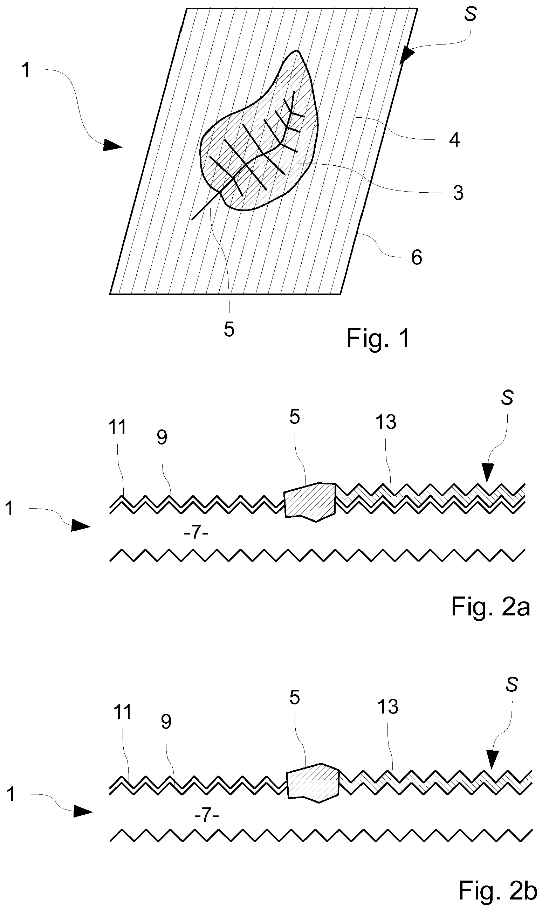

Figure 1 shows a photovoltaic cell 1, presenting its front surface S, which is the surface through which the sunlight enters the cell 1. In the central portion of the photovoltaic cell 1, a portion 3 of the photovoltaic cell shaped so as to form a leaf image is covered with a green colouring layer, in particular a green appearing antireflection coating (ARC) so as to exhibit a green colour, for example due to the selection of an appropriate thickness of said antireflection coating causing enhanced reflection in the green spectral region (500-550nm).

The rest 4 of the photovoltaic cell 1 is covered by a transparent antireflection coating (ARC), and therefore appears blue-grey due to the underlying silicon based solar cell material.

Metallic front contacts 5, 6 are deposited on the front surface S of the photovoltaic cell 1 to extract electric current obtained by photovoltaic effect.

A portion of said front contacts forms decorative front contacts 5 with front contacts deposited around the colour exhibiting portion 3 of the photovoltaic cell 1 so as to form a contour of the leaf shape. Further decorative front contacts 5 are deposited in lines in the centre of the leaf shaped colour exhibiting portion 3 of the photovoltaic cell 1 and depict details in form of a vein system of the leaf.

Other front contacts 6 are deposited according to a regular pattern, here of parallel lines. The regular patterned front contacts 6 are in particular thinner, and/or buried under an antireflection coating or a passivation layer in order to be less apparent when compared to the decorative front contacts 5.

Figures 2a and 2b are cutaway views of possible layer arrangements to obtain the photovoltaic cell 1 previously mentioned.

The photovoltaic cell 1 is represented in figures 2a, 2b with its front surface S oriented upwards.

The lowest layer represented in figures 2a, 2b comprises a silicon crystal cell body, comprising different active layers 7 of the photovoltaic cell 1. The active layers comprise for example a doped silicon substrate, consisting for example of a doped monocrystalline silicon layer, and one or more amorphous hydrogenated silicon nitrite SiN:H layers. The application EP 3 021 366 in the name of the applicant discloses examples of methods to generate what is here called the active layers 7.

The front surface of the active layers 7 is here in particular textured using the random pyramid method, for example with randomly distributed upright pyramids 9. The pyramids 9 consist for example of four planes and four edges with an angle between the planes and the base of about 54,75°. Random texturing may be formed by submitting {100} silicon wafers to a lowly concentrated alkaline solution buffered with isopropyl alcohol (IPA) and containing dissolved silicon at elevated temperature. The conditions are controlled in a way to ensure that the pyramids have for example a height between 1 - 10µm.

Texturing is illustrated on figures 2a, 2b by a saw-tooth profile of the front surface S for improved light trapping. However, other texturing methods may be used like for example in WO2011/023894 in the name of the applicant and enclosed by reference. Although generally realized on wafers to trap sunlight more efficiently, the texturing step is highly recommended with respect to the present invention but not necessary for its functioning.

The textured front surface S is covered with a transparent antireflection coating 11. This antireflection coating 11 can in particular be a layer of one of the following materials: silicon nitride SiNₓ, silicon oxide SiOₓ, silicon carbide SiC, aluminium nitride AIN, aluminium oxide AlOₓ, titanium oxide TiOₓ, silicate glass. The different materials can be deposited either by chemical vapour deposition (in particular plasma enhanced chemical vapour deposition PECVD) sol-gel deposition, spin coating or by sputtering.

In the central portion of the partially represented photovoltaic cell 1 in figure 2a, a metallic front contact 5 is represented, forming a separation between the coloured and uncoloured portions 4 of the front surface *S*, and thus contouring the colour exhibiting portion 3 or portions of the decorative pattern.

The term "contour" designates here the separation line of two different colour exhibiting portions 3 covered with additional antireflection coating layers 13 (of different thicknesses/colours), or the separation line of a colour exhibiting portion 3 and a the rest 4 of the solar cell 1, for example covered in transparent antireflection coating 11.

On the right portion of the represented portion of a cell 1, an additional colouring layer 13 of antireflection coating is deposited. The colouring layer 13 is for example a stack of two or more layers of different antireflection coating materials as previously mentioned, selected with different refraction indexes, or a layer of tinted silicate glass.

In particular, the colouring layer 13 can comprise stacked SiO₂ and SiNₓ:H layers, with thicknesses of 0 to 300nm.

If used, tinted silicate glass can for example be tinted with metal oxides, or with quantum dots of appropriate size. The thickness of the colouring layer 13 and the content of tinting material can be adapted to the desired colour brightness.

The coloured 3 and uncoloured portions 4 of the front surface S are separated by a metallic contact 5, the top surface of which is apparent, and which is fired through the antireflection coating 11 so as to be in electrical contact with the active layers 7 where carriers are generated.

In figure 2b, an alternative example of structure of a photovoltaic cell is represented. In said example, the colouring layer 13 is deposited directly on the active layers 7 of the cell 1, and also acts as the antireflection coating on the portions of the front surface S it covers, without underlying uncoloured antireflection coating 11.

A further example, derived from the ones of figures 2a and 2b is obtained in covering the different portions of the front surface with different colouring layers 13, with different colours, with or without underlying uncoloured antireflection coating 11.

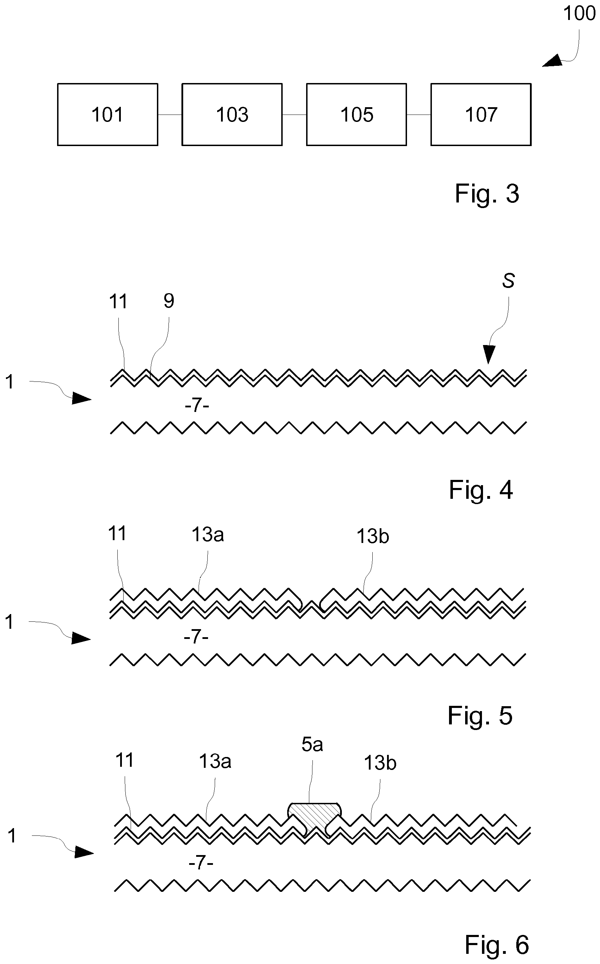

Figure 3 is a schematic linear flowchart containing the main steps of a process 100 to generate the photovoltaic cell 1, the main steps being illustrated in figures 3 to 7.

The starting point 101 of the process 100 is a finished or semi-finished photovoltaic cell, for example a single crystal doped silicon cell made of a thin doped single crystal silicon sheet.

A finished photovoltaic cell would for example be a cell with active layers 7, covered with an uncoloured or transparent antireflection coating 11. A semi-finished photovoltaic cell 1 would comprise the active layers 7, with a topmost passivation layer and no antireflection coating 11.

The starting point represented in figure 4 is a photovoltaic cell 1 with a transparent antireflection coating 11.

The first step 103 is the deposition of the antireflection coating 11 and/or colouring layers 13a, 13b, which can in particular be done using chemical vapour deposition. For example, masks can be used to cover specifically the portions of the front surface S which are not to be coloured in the currently deposited colour.

As an alternative, the colouring layers 13a, 13b can be deposited selectively on the intended area using so called patterned electrodes. Suitable electrodes for depositing the colouring layers 13a, 13b on specific areas 3 of the front surface S while preserving the rest 4 are described in WO/2017/037064, entitled "PLASMA GENERATING APPARATUS AND METHOD OF MANUFACTURING PATTERNED DEVICES USING SPATIALLY RESOLVED PLASMA PROCESSING."

The patterned electrodes therein comprise recesses and protrusions facing the front surface S. The voltage difference and working pressure are chosen so that the recesses and/or the protrusions form spatially isolated plasma chambers, under which the chemical deposition takes place on the substrate 1 in a spatially resolved way.

In figure 5, the represented solar cell 1 comprises two different colouring layers 13a and 13b with different colours. Small gaps (as depicted in figure 5) or overlapping areas of the different coloured areas 13a, 13b can remain, as the interface between the surfaces of different colours 13a, 13b will be covered with the metallic contacts 5

The second step 105 is the deposition of the metallic front contacts 5 along the desired contact pattern, providing electrical connection for the generation of electrical current using the photovoltaic effect, forming at least partially contours of the different antireflection coating surfaces with different colours 13a, 13b.

The metallic contacts are here in particular obtained by printing a metallic and glass particle containing paste 5a along the intended contact pattern, the glass particles acting as fritting material. The paste 5a is for example screen or jet printed on the interface between the surfaces of different colours 13a, 13b. The metal can be silver or aluminium, and in particular an eutectic mixture of metals.

In figure 6, the paste 5a destined to form the metallic contacts 5 is depicted on the interface between the coloured surfaces 13a, 13b of different colours 13a, 13b. The applied paste 5a bridges the gap between the coloured surfaces 13a, 13b.

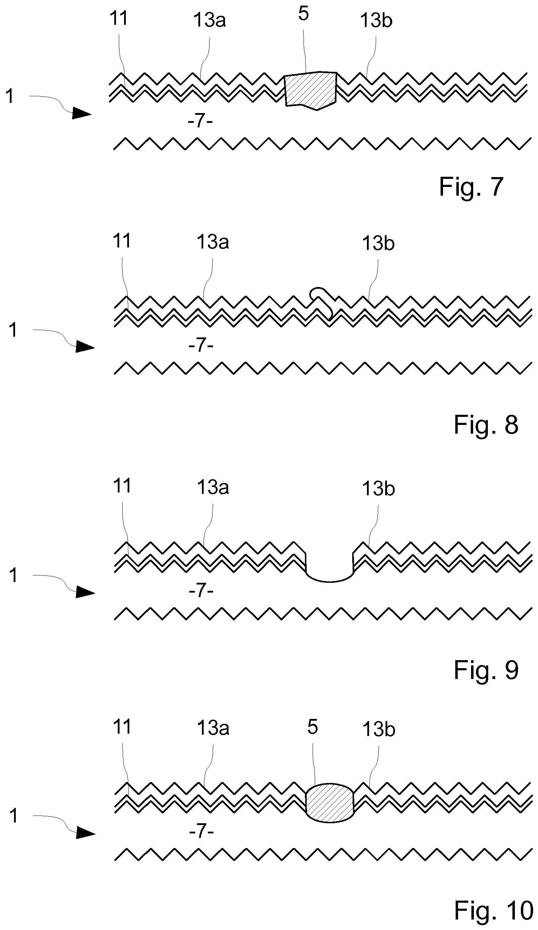

The cell 1 with the paste 5a is then heated in the following step 107, in particular using local laser heating, to cause melting of the colouring layers 13a, 13b, the antireflection coating 11, a portion of the underlying active layers 7, the fritting glass particles and the metallic particles to form the metallic contacts 5. The obtained photovoltaic cell 1 is depicted in figure 7.

As an alternative, the antireflection coating 11, the colouring layers 13a, 13b and the underlying passivation layer of the active layers 7 can be selectively etched away using jet printing of acid, and the metallic contacts 5 can be electroplated on the opened metallic contact pattern.

The deposited metallic contacts 5 can then be either polished to appear shiny, or treated or patinated so as to appear matte. Specific metallic alloys, or suspensions of ceramic particles can be added to the metallic paste, or be deposited or plated afterwards on the metallic contacts to further alter their appearance. Coating, painting, bronzing and/or acid, alkali or heat treatments, in particular with laser irradiation for precision, to alter their appearance are also possible. Reactants can in particular be screen printed specifically on the metallic contacts 5.

Figures 8 to 10 depict a further alternative method to deposit the metallic front contacts 5.

In figure 8, the photovoltaic cell 1 is represented in a similar fashion and state as in figure 5, with the coloured antireflection coating layers 13a, 13b presenting this time an overlap at their separation, for example of several micrometres.

To deposit the metallic contacts 5, the coloured antireflection layers 13a, 13b, the uncoloured antireflection coating 11 and the underlying passivation layer or layer of the active cell layers 7 is ablated using laser ablation along the intended metallic contact 5 pattern. The laser ablation is performed using for example pulsed high energy green (532nm Nd:YVO4 laser) or ultraviolet (335nm Nd:YAG laser) laser light pulses, with careful calibration of radiated power, pulse length and frequency to avoid excessive damage to the underlying bulk silicon in the active cell layers 7.

The cell 1 with ablated portions is represented in figure 9. In particular, the overlapping portion of the coloured antireflection layers 13a, 13b is ablated.

The metallic contacts 5 are then electroplated on the ablated metallic contact 5 pattern. Decorative metallic contacts 5 not forming contours can additionally be ablated and plated inside the coloured surfaces 3 during the previous ablating and electroplating steps.

Further embodiments can comprise steps of etching away of the antireflection coating 11 before application of one or more of the colouring layers 13a, 13b.

Furthermore, one or more of the colouring layers 13a, 13b can comprise two or more layers of tinted silicate glass, in particular in a set of primary colours, the relative thickness of the tinted silicate glass layer of each colour contributing to the overall colour of the considered surface portion 3.

The obtained cells 1 can then be arranged in a solar or photovoltaic module, for example in a row and column pattern in series and parallel to generate the desired electrical current and voltage. Said solar module is then integrated in a photovoltaic assembly, possibly comprising multiple solar modules and electrical collecting and adaptation circuitry to store and/or inject the generated power in a domestic or public grid.

In a particular embodiment, the cells 1 are made of a thin silicon substrate (few hundred micrometres) so as to be flexible. The cells 1 and interconnecting metallic contacts are then arranged on a support sheet, in particular a flexible polymer sheet. The active layers 7 can in particular be thin enough to remain flexible (few hundred micrometres), so as to obtain a flexible photovoltaic cell 1, and a flexible photovoltaic module. In the case of solar cells 1, the term flexible is used to mean that a certain curvature radius can be applied to said cell, without excessively damaging its crystalline structure, and in particular without significant loss of structural properties and/or power conversion efficiency.

The support sheet carrying the cells 1 is then laminated between a transparent polymer front sheet and a back sheet to manufacture the photovoltaic module.

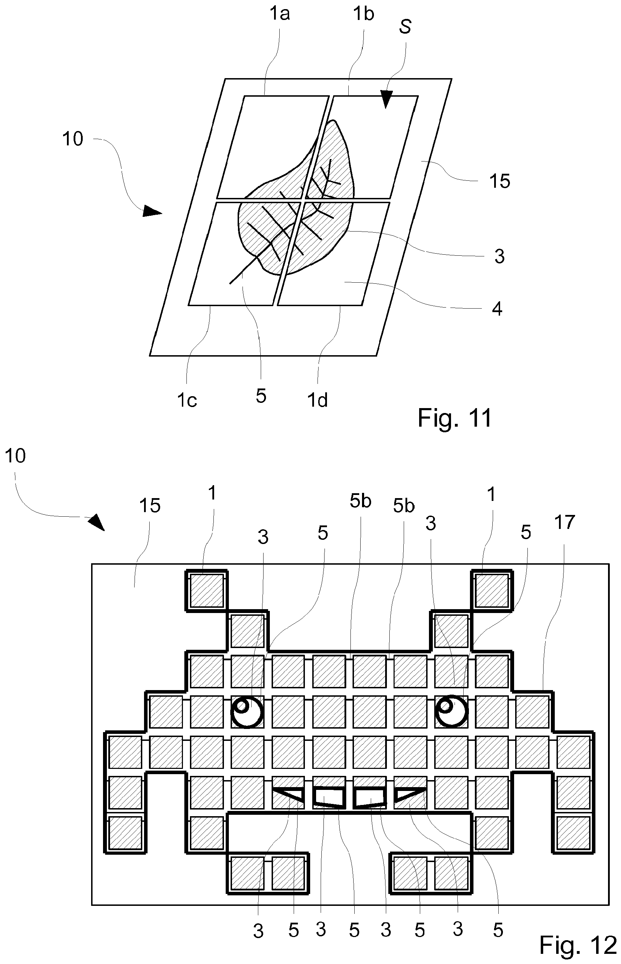

Figure 11 depicts a photovoltaic module 10 for example manufactured according to the previously mentioned method. The photovoltaic module 10 comprises four photovoltaic cells labelled 1a, 1b, 1c, 1d, placed close to each-other two by two in columns and rows on a support layer 15.

The decorative pattern on each of the photovoltaic cells 1a, 1b, 1c, 1d is a portion of a bigger decorative pattern, completed when the photovoltaic cells are placed close to each other on the photovoltaic module 10. For example in figure 7, each of the cells 1a, 1b, 1c, 1d presents a colour exhibiting portion 3 of its front surface S representing a quarter of the leaf shaped pattern. The finished photovoltaic module 10 with the arranged cells 1a, 1b, 1c, 1d consequently carries the completed leaf pattern.

The process according to the invention can also be applied to the rear or back surface (opposite the front surface S) if said surface is apparent in the installed photovoltaic assembly or module 10.

Portions of the front surface of the photovoltaic module 10 can also remain free from photovoltaic cells 1. Such a photovoltaic module 10 is represented in figure 12.

In figure 12, the photovoltaic module 10 comprises multiple photovoltaic cells 1 arranged in a pattern, representing here a pixel crab. Some of the cells 1 are decorated with colour exhibiting portions 3, in particular to form eyes for the crab and a smiling mouth stretched over horizontally adjacent photovoltaic cells 1. The colour exhibiting portions 3 of the decorated cells 1 are contoured with larger, decorative metallic contacts 5.

The different cells 1 are interconnected by contacts 5b in series and parallel to optimize the expected output current and voltage. Said interconnection contacts 5b are printed or deposited on the support sheet 15, and are here in particular thinner than the decorative metallic contacts 5 on the decorated photovoltaic cells 1.

The contacts printed on the support sheet 15 comprise an additional contact portion 17, which forms additional decorative details, in particular an overall contour of the cell pattern. The exterior contour forming additional contact portion 17 is thicker than the interconnection contacts 5b between the cells. In particular, said contact portion 17 is of comparable thickness with the decorative contacts 5 of the decorated cells 1, and can be treated with the same process (patination, polishing, painting etc.) to present a comparable aesthetic aspect.

The process according to the invention allows incorporating the metallic contacts 5 in the decorative pattern of coloured 13 and transparent antireflection coating 11 layers in an aesthetic fashion. The metallic contact contouring also allows reducing the precision constraints during application of the colouring layers 13, since gaps and overlap areas will be covered by the metallic contacts 5.

The presence of additional metallic contacts 5, as contours and decorative details, also improves the current extraction, so that the slight active front surface S loss and the efficiency losses due to the additional, coloured antireflection coating layers 13a,13b are at least partially compensated.

## Claims

1. Photovoltaic cell, comprising :
- a silicon crystal cell body (7) comprising a cell front surface (S),
- an antireflection coating covering (11, 13) at least partially the cell front surface (S), comprising at least two surfaces (3, 4) exhibiting different colours forming a decorative pattern,
- metallic front contacts (5), providing electrical connection for the generation of electrical current using the photovoltaic effect, forming at least partially a contour of one of the two antireflection coating surfaces (3, 4) exhibiting different colours.

2. Photovoltaic cell according to claim 1, **characterized in that** a portion of the metallic front contacts (5) also forms decorative details of the decorative pattern.

3. Photovoltaic cell according to claim 1 or 2, **characterized in that** the antireflection coating (11, 13) comprises at least two layers of different thickness for each of the at least two surfaces (3, 4) of different colours, of two of the following materials : silicon nitride SiNx, silicon oxide SiOx , silicon carbide SiC, aluminium nitride AIN, aluminium oxide AlOx, titanium oxide TiOx.

4. Photovoltaic cell according to any of the preceding claims, **characterized in that** the antireflection coating (13) comprises a layer of tinted silicate glass.

5. Photovoltaic cell according to any of the preceding claims, **characterized in that** the metallic front contacts (5) are printed front contacts, obtained by printing a metallic particle containing paste (5a) and thermal firing through of said paste (5a).

6. Photovoltaic cell according to any of claims 1 to 4, **characterized in** the metallic front contacts (5) are obtained by plating of metal on a laser ablated contact pattern.

7. Photovoltaic module, comprising at least one photovoltaic cell (1) according to any of the preceding claims.

8. Photovoltaic module according to claim 6, **characterized in that** it comprises a support sheet (15), on which the photovoltaic cells (1) are arranged in a pattern, and **in that** the support sheet (15) comprises an additional metallic contact (17) forming additional decorative details.

9. Process for manufacturing a photovoltaic cell, comprising the steps :
• depositing an antireflection layer (11, 13) on a front surface of a photovoltaic cell comprising at least two surfaces (3, 4) of different colours forming a decorative pattern,
• depositing metallic front contacts (5), providing electrical connection for the generation of electrical current using the photovoltaic effect, forming at least partially a contour of one of the two antireflection coating surfaces (3, 4) with different colours.

10. Process according to claim 9, **characterized in that** it further comprises the step :
• depositing additional metallic front contacts (5) forming decorative details of the decorative pattern.

11. Process according to claim 9 or 10, **characterized in that** the electric contacts are deposited by printing of a metal containing paste (5a) and thermal firing of said paste (5a).

12. Process according to claim 9 or 10, **characterized in that** the step of depositing metallic contacts (5) and/or additional metallic contacts (5) comprises the steps :
• performing laser ablation of the antireflection coating (11, 13) and passivation layers of the photovoltaic cell (1) along the intended metallic contact (5) pattern,
• electroplating of metallic contacts (5) on the laser ablated metallic contact (5) pattern.

13. Process according to any of claims 9 to 12, **characterized in that** the antireflection coating (11, 13) is deposited using chemical vapour deposition and masks.

14. Process according to any of claims 9 to 12, **characterized in that** the antireflection coating (13) is deposited using plasma enhanced chemical vapour deposition and patterned electrodes to selectively deposit the antireflection coating layers (11, 13) on the at least two surfaces (3, 4) of different colours forming a decorative pattern.

15. Process according to any of claims 9 to 14, **characterized in that** the photovoltaic cells (1) and the metallic contacts (5) are deposited on a polymer support sheet, which is then laminated between a transparent polymer front sheet and a back sheet.
